# EUROPEAN PATENT SPECIFICATION

(11) **EP 0 493 615 B1**
(45) Date of publication and mention of the grant of the patent: **20.05.1998**
(21) Application number: 91913084.9
(22) Date of filing: 19.07.1991
(51) Int. Cl.: H01L 27/04, H01L 27/10, H01L 27/108, H01L 27/02

(54) **SEMICONDUCTOR INTEGRATED CIRCUIT DEVICE**
INTEGRIERTE HALBLEITERSCHALTUNGSANORDNUNG
DISPOSITIF A CIRCUITS INTEGRES A SEMI-CONDUCTEURS

(30) Priority: 23.07.1990 JP 194237/90
(43) Date of publication of application: 08.07.1992
(73) Proprietor: SEIKO EPSON CORPORATION, Shinjuku-ku Tokyo 163-08 (JP)
(72) Inventor: SASAKI, Minoru, 3-5, Owa 3-chome, Nagano-ken 392 (JP)
(74) Representative: Hoffmann, Eckart, Dipl.-Ing.
(86) International application number: PCT/JP91/00970
(87) International publication number: WO 92/02043

(56) References cited:
- EP-A- 0 041 844
- JP-A-60 182 742
- JP-A-63 199 444
- JP-U-63 188 949

## Description

### BACKGROUND OF THE INVENTION

### Industrial Field

The present invention relates to a layout of a semiconductor integrated circuit device in which a plurality of signal wirings are arranged in parallel with power supply wirings like signal wirings for driving a decoder circuit in a memory chip, and more particularly to a semiconductor integrated circuit device using two layers and more of wiring layers.

### Related Art

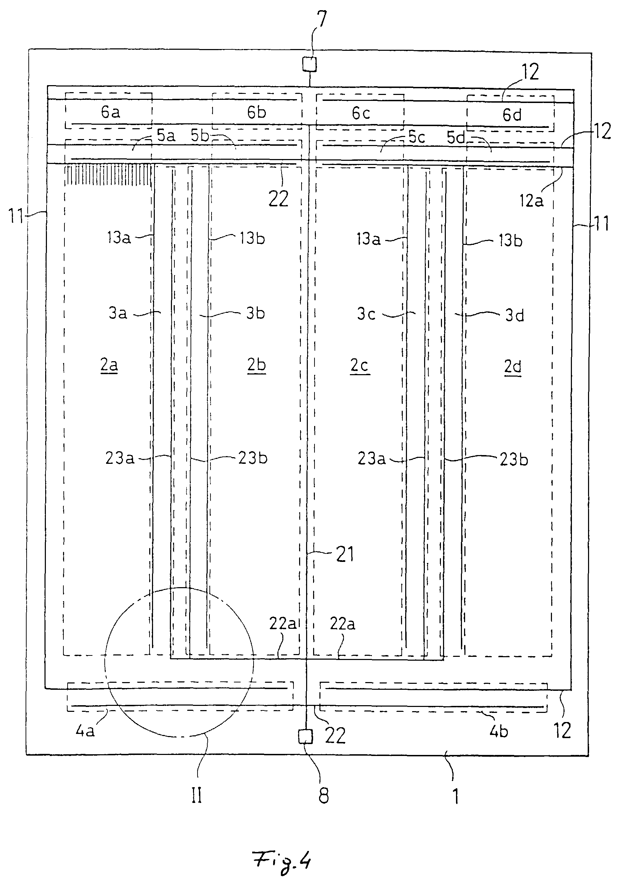

Fig. 4 shows a layout of a conventional memory chip. The present memory chip 1 is a read-only memory (ROM), and is composed of four memory cell blocks 2a to 2d. Between the memory cell blocks 2a and 2b are arranged a row decoder circuit 3a including a decoder and a buffer for driving a word line of the memory cell block 2a and a row decoder circuit 3b of the memory cell block 2b so as to confront each other. Between the memory cell blocks 2c and 2d are also arranged respective row decoder circuits 3c and 3d so as to confront each other.

In an upper part of Fig. 4, column decoder circuits 5a to 5d and sense amplifier circuits 6a to 6d for processing signals of bit lines of respective memory cell blocks 2a to 2d are arranged for the memory cell blocks 2a to 2d. On the other hand, in a lower part of Fig. 4, peripheral circuits 4a and 4b including predecoder circuits in which signals for driving the row decoders and so forth are generated are arranged for the memory cell blocks 2a to 2d on the opposite side of these circuits. This peripheral circuit 4a is a circuit common to the decoder circuits 3a and 3b, and arranged under the memory cell blocks 2a and 2b. Further, the peripheral circuit 4b is a circuit common to the decoder circuits 3c and 3d, and arranged under the memory cell blocks 2c and 2d.

In the arrangement of power supply wirings for supplying power to these circuits, first a pad 7 supplied with Vss (0V) is installed on the outer circumferential side of the sense amplifier circuits 6a and 6b. On the other hand, a pad 8 supplied with Vdd (5V) is arranged on the outer circumferential side of the predecoder circuits 4a and 4b. A mother wiring 11 is arranged around the chip 1 from the pad 7, and Vss is applied to respective circuits by branch wirings 12 which are arranged in parallel with respective circuits so as to run towards the center of the chip 1 from the mother wiring 11. Furthermore, in the memory cell blocks 2a to 2d and the row decoder circuits 3a to 3d, Vss is supplied to respective cells 2a to 2d or circuits 3a to 3d through branch wirings 13 branched further from a part 12a of the branch wirings 12.

On the other hand, a mother wiring 21 is arranged from a pad 8 through between memory cell blocks 2b and 2c which are the center of the memory chip 1, and Vdd is supplied to respective circuits through branch wirings 22 arranged in parallel with respective circuits from the mother wiring 21 toward the circumference of the chip 1. In the row decoder circuits 3a to 3d, Vdd is supplied to the decoder circuits 3a to 3d through branch wirings 23 branched further from a part 22a of the branch wiring 22.

As described above, the supply wirings of two power supplies, Vss and Vdd, are arranged in separated positions so that Vss is supplied from the outer circumference to the center of the chip 1 and Vdd is supplied from the center to the outer circumference. By adopting such a layout that wiring channels of Vss and Vdd are separated, wirings of Vss and Vdd are made not to intersect each other.

In the chip 1 having such a layout, a region II where signal wirings which connect the peripheral circuits 4a and 4b and the row decoders 3a to 3d with one another gather together is a region where signal wirings and power supply wirings intersect one another, and is also one of wiring channels having the highest density in the chip 1. Thus, it is one of the most important factors for determining access speed and chip size of the memory chip 1 how the layout of the region II is to be determined.

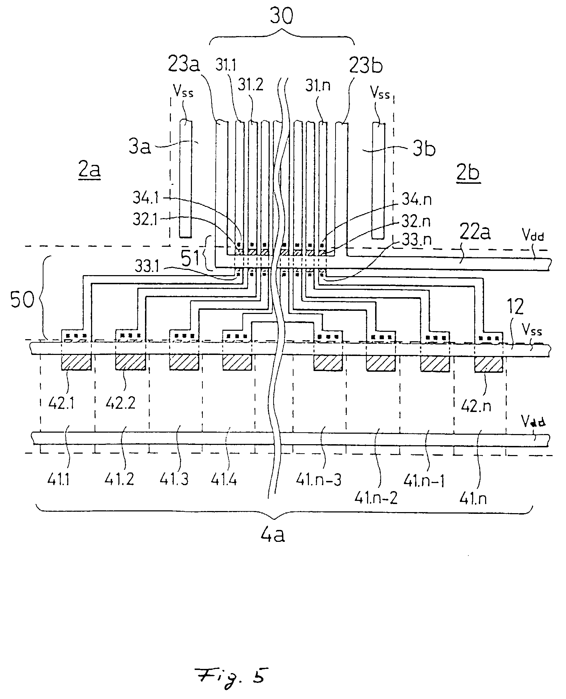

Fig. 5 shows a layout of the region II in a conventional device. In a common bus line region 30 between the row decoder circuits 3a and 3b, n lines of signal wirings 31.1 to 31.n from the peripheral circuit 4a to the decoder circuits 3a and 3b are arranged in parallel with one another while being placed between power supply wirings 23a and 23b. These wirings 31.1 to 31.n are connected with respective connecting portions 42.1 to 42.n of n pieces of function cells 41.1 to 41.n of the peripheral circuit 4a. The wirings for signals outputted from these connecting portions 42.1 to 42.n generally intersect with the power supply wiring 12 of the peripheral circuit 4a which is laid out along both ends of the peripheral circuit 4a. As a result, these connecting portions 42.1 to 42.n are formed by a polycrystalline silicon wiring layer provided below the power supply wiring 12 with an insulating layer in between. Further, logic circuits being arranged inside, respective function cells 41.1 to 41.n are arranged in a region having a width wider than the width of the common bus line 30 where respective signal wirings 31.1 to 31.n are arranged collectively. As a result, respective signal wirings 31.1 to 31.n connected with connecting portions 42.1 to 42.n arranged in respective function cells 41.1 to 41.n are assembled toward the common bus line 30 using the portion between the row decoder circuits 3a and 3b and the peripheral circuit 4a as an assembling region 50.

The signal wirings 31.1 to 31.n thus assembled intersect with the power supply wiring 22a of the row decoders 3a and 3b in a contracted region 51 at an inlet portion to the common bus line 30. Therefore, wiring is made using wirings 32.1 to 32.n in a second layer of highly resistive polycrystalline silicon formed with an insulating layer put therebetween under the power supply wiring 22a in the inlet portion 51 of respective signal wirings 31.1 to 31.n. Further, the wirings 32.1 to 32.n in the second layer and respective signal wirings 31.1 to 31.n are connected with one another through two via holes, a via hole 33 on the peripheral circuit 4a side and a via hole 34 on the common bus line side for every wiring.

In a memory chip having the layout as described above, some of the problems preventing an increase of memory capacity and achievement of higher access speed are problems related to the region II where above-described signal wirings are assembled. Namely, such a tendency is developed that the area of the memory region is increased along with the increase of the memory capacity and the number of lines of the signal wirings to the decoder is also increased, but the size of the chip is limited due to the relation with package and the like, and it is difficult to widen the width of the common bus line. Accordingly, such a tendency is developed that the width of signal wirings is narrowed, and similarly, the wiring width of the second layer of polycrystalline silicon has also to be reduced. Since polycrystalline silicon forming wirings in the second layer has a high resistance, it happens frequently that a resistance value of the wiring is increased sharply due to the reduction of the wiring width, and thus resulting in reduction of the access speed to the decoder. Therefore, the access speed to the memory is reduced.

The number of via holes for connecting the wirings in the second layer with signal wirings has to be reduced at the same time, and the resistance of this portion is also increased. Therefore, the access speed is reduced further.

Moreover, it is required to form a plurality of via holes in accordance with the number of lines of signal wirings in a limited wiring region as the number of signal wirings is increased. In manufacturing such a region, it is impossible to form all the via holes in perfect shapes, and such defects as via holes having defective connection or high connecting resistance, and via holes short-circuited with adjacent wirings are generated sometimes. Since the percentage of such defects has a tendency to increase as the spacing among via holes gets narrower, the reliability of the memory chip is lowered and the memory of the defective portion cannot be used, thus resulting in reduction in yield.

The document EP-A-0 041 844 discloses a semiconductor intragrated circuit device having a decoder circuit in between a pair of memory cells. Control circuits are disposed in the periphery of the memory cells and decoder circuit. A bus line of signal wirings connecting the decoder circuit with the control circuits surrounds the memory cells and decoder circuit and overlies the contol circuits. Connection lines between the bus line and the decoder circuit intersect a mother power supply wiring provided inside of the bus line and also overlying the control circuits.

### SUMMARY OF THE INVENTION

In view of problems described above, it is an object of the present invention to realize a layout which is able to aim at reduction of wiring resistance without expanding the region required for wirings with respect to a region where the signal wirings are assembled and is also able to aim at improvement of the reliability of wirings and improvement of access speed.

### Disclosure of the Invention

This object is achieved with the invention as claimed in claim 1.

Several means have been proposed as means for solving above-described problems. For example, polycrystalline silicon wirings used in the portion interfering with power supply wirings are made to be wirings made of aluminum of low resistance. However, it is required to form such aluminum wirings in an upper layer of power supply wirings while putting an insulating layer therebetween in order to avoid interference with power supply wirings. Since more process steps are required to form such wiring layer above power supply wirings as compared with polycrystalline silicon wirings which may be formed at the time of surface working of a semiconductor device, it is difficult to adopt such means. Furthermore, even if such a layout is adopted, it is difficult to solve the problems regarding resistance of via holes and reliability described above.

As a proposal for solving the problems including the problem of via holes, a proposal for altering to a layout in which power supply wirings do not intersect with signal wirings has also been made. In order to avoid interference with the signal wirings, however, it is required to arrange power supply wirings from both sides toward the common bus line in a direction perpendicular to the common bus line. Namely, the same power supply wiring is to be arranged both at the center and the circumference of the semiconductor device. Such a layout is not applicable to a semiconductor device in which a layout with the power supply wirings separated is adopted in order to avoid mutual intersection of power supply wirings as described previously. Because, in case the layout is adopted, two types of power supplies are arranged at the same time around the semiconductor, and mutual interference between power supply wirings is produced when power is supplied to respective circuits.

Although it is possible to avoid interference by forming the power supply wirings in two layers, the problem of manufacturing process still remains similarly to the previous proposal in which signal wirings are formed in two layers in the upper part. Furthermore, since the channels of feeding lines of the power supply to decoder circuits associated with respective memory cell blocks are different for every power supply wiring, it becomes difficult to set the potential applied to respective circuits to the same level and also to make the signal level identical.

Against such a proposal, problems as described above are solved in the present invention by arranging that the mother power supply wiring of the common bus line is branched along the vicinity of peripheral circuits such as for signal processing provided around the memory cell blocks. Namely, a semiconductor integrated circuit device having at least a signal processing circuit in which a plurality of connecting regions of signal wirings are arranged discretely and a wiring laying region where signal wirings connected with the signal processing circuit are assembled so as to be in parallel among a plurality of power supply wirings according to the present invention is characterized in that the mother power supply wiring from which power supply wirings are branched is arranged along the vicinity of a connecting region of the signal processing circuit.

It becomes possible to avoid interference between the mother power supply wiring and respective signal wirings in a contracted region corresponding to an inlet portion of the wiring laying region by arranging the mother power supply wiring in the vicinity of the connecting region of the signal processing circuit as described above. Further, since the mother power supply wiring is arranged along the vicinity of the connecting region of the signal processing circuit, it becomes possible to process interference between the mother power supply wiring and signal wirings in the vicinity of that region. The connecting regions of the signal processing circuit are disposed discretely from a space required for logic circuits in the processing circuit. Thus, the spacing among respective signal wirings is secured sufficiently in the vicinity of this region for the signal wirings connected in the connecting region. Accordingly, it is possible to secure wide width of the signal wirings in the second layer required for processing intersection among respective signal wirings and the mother power supply wiring by arranging the mother power supply wiring in the vicinity of this region. As a result, signal wirings in the second layer having low resistance may be realized even in a semiconductor device having a high wiring density of a common bus line which corresponds to a wiring laying region of a memory chip and the like. In addition, it is possible to easily arrange via holes in a quantity sufficient for connecting signal wirings in the second layer and respective signal wirings in the same wiring layer as the mother power supply wiring with one another.

Furthermore, the connecting region of the signal processing circuit is connected with signal wirings using the wiring layer in the second layer in many cases in order to avoid interference with power supply wiring for the signal processing circuit. Therefore, by extending the wiring in the second layer to the portion interfering with the mother power supply wiring, it is possible to reduce the number of connecting points of the signal wirings, and also to aim at reduction of connecting resistance and prevention of deterioration of reliability caused by nonconformity of the connecting points.

In the above-described semiconductor integrated circuit device composed of a plurality of memory cell blocks, the mother power supply wiring may be arranged in the vicinity of a plurality of peripheral circuits which are signal processing circuits arranged around the memory cell region so as to process intersection of the signal wirings connecting the decoder circuits arranged among memory cell blocks with peripheral circuits through the common bus line and the mother power supply wiring. Further, power supply wirings branched from the mother power supply wiring are assembled in the common bus line in parallel with these signal wirings, and thus, will never intersect again at an inlet portion of the common bus line and the like. Further, the power supply to the decoder circuits arranged on both sides of the common bus line may be applied through one mother power supply wiring similarly as before. Therefore, it is not required to give consideration to potential variation and interference with other power supply wirings.

Since it is possible to secure sufficient distance for the spacings in respective connecting regions of peripheral circuits and signal wirings by adopting such a layout, it is possible to form signal wirings in the second layer having a large area showing low resistance. Further, since it is also possible to secure a large area at the connecting portion of signal wirings in the second layer and the first signal wiring in the same layer as the mother power supply wiring, it is possible to connect the first and second signal wirings with each other using a plurality of via holes. Thus, it is possible to aim at reduction of the resistance at the connecting portion. Moreover, nonconformity of via holes which may be produced in the manufacturing process can be solved by forming a plurality of via holes in a connecting portion at one location. As a result, in a semiconductor integrated circuit device according to the present invention, it is possible to prevent reduction in the access speed with the increase of the resistance of the signal wirings and also to prevent deterioration of reliability in connection with via holes at the same time.

Furthermore, since the power supply wirings to peripheral circuits are arranged generally on the connecting region of peripheral circuits, the above-described mother power supply wiring is to be arranged in parallel with the power supply wiring to the peripheral circuits. With such an arrangement, it is possible to extend the connecting region formed in the wiring layer of the second layer to the intersecting portion with the mother power supply wiring in order to avoid interference with the power supply wiring to the peripheral circuits. In this case, it is possible to reduce two wirings in the second layer which have been heretofore required for avoiding interference with the power supply wirings to the peripheral circuits and for avoiding interference with the mother power supply wiring to one wiring in the second layer which is common to the power supply wiring to the peripheral circuits and the mother power supply wiring. Accordingly, it is possible to aim at reduction of the connecting resistance with the wirings in the second layer, and at the same time, to reduce nonconformity in point of manufacturing occurring frequently at the connecting portion by reducing the number of connecting portions, thereby to aim at improvement of reliability of the device.

Furthermore, in a device in which the power supply wiring to the peripheral circuits and the mother power supply wiring are in parallel with each other and power consumption in the peripheral circuits is stabilized, it is also possible to form the power supply wirings to the peripheral circuits and the mother power supply wiring into a common wiring. In case such a layout is adopted, the wiring in the second layer may be made shorter. Hence, further reduction of the wiring resistance may be expected in addition to above-described effects.

Further, in a general semiconductor integrated circuit device, the common bus line and the mother power supply wiring meet at right angles with each other in many cases from the viewpoint of interference among power supply wirings and the layout of function cells. This is a matter of course in a device having such a layout, but, in a semiconductor device in which the power supply wirings are branched to the common bus line from the mother power supply wiring, the present invention is also applicable even in case the common bus line and the mother power supply wiring do not meet at right angles with each other.

Aluminum wirings having low resistance may be used for the wirings in the first layer which is the same as the mother power supply wiring as above-described signal wirings. Further, both aluminum wirings and polycrystalline silicon wirings may be used for the wirings in the second layer formed through an insulating layer in the upper part or the lower part of this first layer. The aluminum wirings are of low resistance, but required to be added to the upper side of the first layer in general. On the contrary, the polycrystalline wirings have an advantage that they may be formed simultaneously with surface working of the semiconductor device inspite of high resistance. Further, since it is possible to secure sufficient width of the wirings of the second layer in the present invention, it is possible to form signal wirings of the second layer having low resistance by using polycrystalline silicon wirings.

### BRIEF DESCRIPTION OF THE DRAWINGS

Fig. 1 is a layout diagram for explaining power supply wiring arrangement of a semiconductor integrated circuit device according to the embodiment 1 of the present invention;
Fig. 2 is a layout diagram showing a portion where signal wirings are assembled in a common bus line according to the embodiment 1;
Fig. 3 is a layout diagram showing a portion where signal wirings are assembled in a common bus line according to the embodiment 2 of the present invention;
Fig. 4 is a layout diagram for explaining power supply wiring arrangement of a conventional semiconductor integrated circuit device; and
Fig. 5 is a layout diagram showing a conventional portion where signal wirings are assembled in a common bus line.

### PREFERRED CONFIGURATIONS FOR IMPLEMENTING THE INVENTION

Preferred configurations for implementing the present invention will be described hereinafter with reference to the drawings.

### (Embodiment 1)

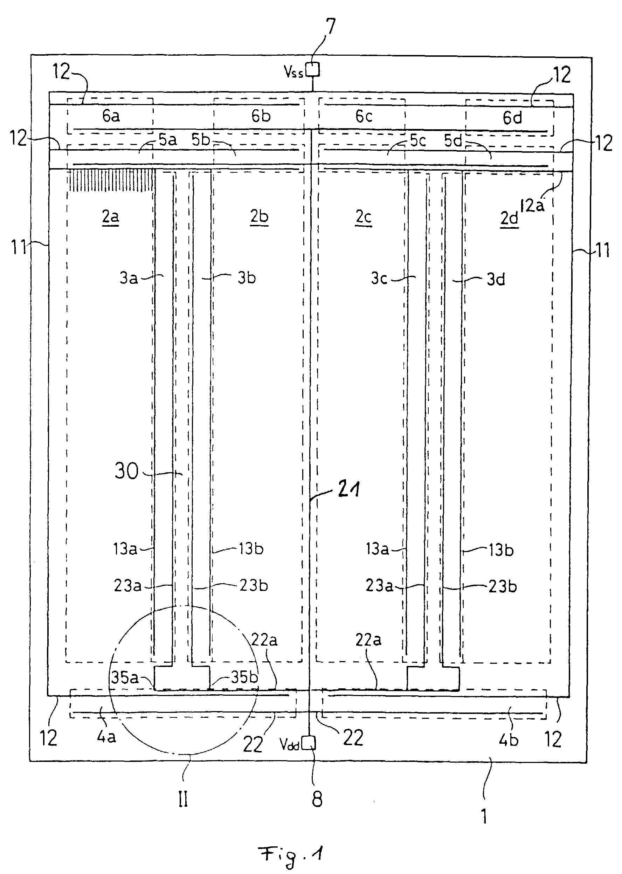

Fig. 1 shows a layout of a semiconductor integrated circuit device according to the embodiment 1 of the present invention. The semiconductor device in the present embodiment is a memory chip of a read-only memory (ROM) similarly to the conventional device described above, and is composed of four memory cell blocks 2a to 2d. Row decoder circuits 3a and 3b, and 3c and 3d are arranged between memory cell blocks 2a and 2b and between 2c and 2d, respectively, so as to confront each other. Further, in the lower part in the figure of column decoder circuits 5a to 5d, sense amplifier circuits 6a to 6d and memory cell blocks 2a to 2d which are located on the opposite side of above-described circuits, peripheral circuits 4a and 4b including predecoder circuits in which signals for driving row decoders are generated are arranged. The arrangement of respective cells and circuits is similar to that of a conventional device described above. Hence, the same numerals are assigned to them and description will be omitted.

On the other hand, in the layout of the power supply wirings which apply the power supply to these circuits, the wirings of Vss and Vdd are made so that wirings of Vss and Vdd do not intersect each other similarly to a conventional device, and a layout in which wiring channels of Vss and Vdd are separated from each other is adopted. Namely, first Vss is supplied to respective circuits through branch wirings 12 so as to run toward the center of a chip 1 through a mother wiring 11 arranged around the chip 1 from a pad 7. Further, Vss is also supplied to the memory cell blocks 2a to 2d and row decoder circuits 3a to 3d through branch wirings 13 branched further from a part 12a of the branch wirings 12. Further, Vdd is supplied to respective circuits with branch wirings 22 from a pad 8 through a mother wiring 21 arranged at the center of the memory chip 1. In the row decoder circuits 3a to 3d, Vdd is supplied to the decoder circuits 3a to 3d through further branched branch wirings 23 from a part 22a of branch wirings 22.

The point to be noticed in the present embodiment is the arrangement of the power supply wiring 22a in a region II where signal wirings for connecting peripheral circuits 4a and 4b which are one of wiring channels having the highest density in the chip 1 with row decoders 3a to 3d are assembled. In a conventional semiconductor device described above, power supply wirings 22a which have been arranged just under decoder circuits 3a and 3b are arranged just above the peripheral circuit 4a. Further, branch points 35a and 35b of wirings 23a and 23b which branch from the power supply wiring 22a are arranged outside the signal wirings 31.1 to 31.n which are assembled in a common bus line 30 from the peripheral circuit 4a. Further, these two lines of power supply wirings 23a and 23b are assembled in the common bus line 30 so as to form a convex form (nearly inverted Y form) along the outer circumference of the signal wirings 31.1 to 31.n.

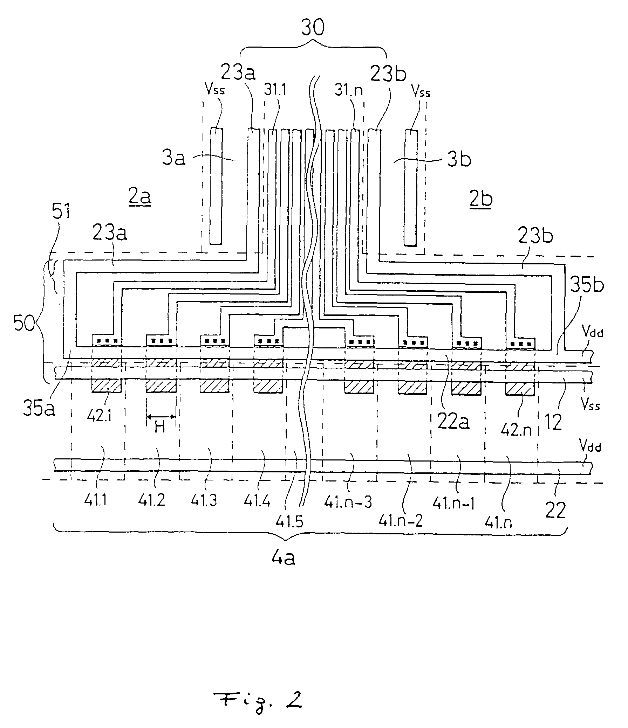

Fig. 2 shows details of the region II where the signal wirings 31.1 to 31.n are assembled in the common bus line 30. The layout of the present region II is almost similar to that of above-described conventional device, and n lines of signal wirings 31.1 to 31.n for connecting the peripheral circuit 4a and the decoder circuits 3a and 3b with one another are arranged in parallel being put between power supply wirings 23a and 23b in the common bus line 30 between the row decoder circuits 3a and 3b. These wirings 31.1 to 31.n are connected with connecting portions 42.1 to 42.n of respective function cells 41.1 to 41.n of the peripheral circuit 4a.

These connecting portions 42.1 to 42.n are formed of polycrystalline silicon in a layer below the wiring layer of signal wirings 31.1 to 31.n, and the mother wiring 22a of power supply wirings 23a and 23b of the row decoders 3a and 3b is arranged in parallel with the power supply wiring 12 of the peripheral circuit 4a above the connecting portions 42.1 to 42.n. Further, the power supply wirings 23a and 23b are branched from the mother wiring 22a located outside the cells 41.1 and 41.n at both ends of the function cell 41 at branch points 35a and 35b. The branched power supply wirings 23a and 23b are arranged so as to meet at right angles with the mother wiring 22a along the outside of signal wirings 31.1 and 31.n at both ends which are assembled in the common bus line 30, and are bent thereafter toward the bus line 30 at the lower ends of the memory cell blocks 2a and 2b which are in parallel with the contracted region 51 which is an inlet portion of the common bus line 30. Further, the power supply wirings 23a and 23b are bent again at portions corresponding to both ends of the common bus line 30 so as to meet at right angles with the mother wiring 22a, and are arranged so as to run along the row decoders 3a and 3b.

In the semiconductor device of the present embodiment, a layout as described above is adopted, and the mother wiring 22a is arranged above the connecting portions 42.1 to 42.n of the peripheral circuit 4a. Thus, the interference between the signal wirings 31.1 to 31.n and the mother wiring 22a is processed in the connecting portions 42.1 to 42.n. Accordingly, there is no interference with the mother wiring 22a in the contracted region 51 at the inlet portion of the common bus line 30 as in a conventional semiconductor device, signal wirings in the second layer of polycrystalline silicon which have been concentrated at the narrow inlet portion 51 are omitted, and all the signal wirings 31.1 to 31.n are wired with aluminum wirings having low resistance. As a result, the resistance of the signal wirings 31.1 to 31.n may be reduced. Furthermore, since via holes required for connection with the second layer can also be omitted, reduction of connecting resistance caused by connecting points is also aimed at. Therefore, the resistance of the wirings 31.1 to 31.n is reduced further lower than before, and improvement of the signal transmitting speed related to the signal wirings 31.1 to 31.n is aimed at.

Further, since via holes concentrated in a conventional small inlet region have been removed, it is possible to prevent nonconformity such as short-circuit and disconnection caused by improper manufacturing of via holes, thereby to realize a highly reliable memory cell block. Further, since it is not required to give consideration to manufacturing limits of via holes in designing the common bus line 30, it becomes possible to increase the quantity of signal wirings arranged in the bus line 30 and to aim at improvement of production yield.

On the other hand, for the spacing among the connecting portions 42.1 to 42.n interfering with the mother wiring 22a, sufficient spacing is secured as compared with the width of signal wirings 31.1 to 31.n by the arrangement of logic circuits included in the function cells 41.1 to 41.n. Accordingly, the connecting portions 42.1 to 42.n are of polycrystalline silicon having high resistance, but the width H of each of the connecting portions 42.1 to 42.n is secured so that the resistance value thereof becomes sufficiently small. Further, it is possible to form a plurality of via holes 43 extending over this width H. Thus, a plurality of via holes are formed for one connecting portion. Therefore, even if one of via holes is not connected due to a fault in a manufacturing process, it is possible to maintain connection with other via holes, thus making it possible to form a highly reliable connecting portion. Since sufficient spacings among respective connecting portions are secured, short-circuit will neither be produced in the manufacturing process.

Furthermore, in the present embodiment, the power supply wiring 12 of Vss to the peripheral circuit 4a and the mother wiring 22a of Vdd to the decoder circuit are arranged closely to each other in parallel. As a result, intersections of these two lines of wirings 12 and 22a with the signal wirings 31.1 to 31.n are processed only by the connecting portions 42.1 to 42.n, and the number of connecting points with the wirings in the second layer formed under the power supply wiring is also reduced as compared with a conventional layout.

As described above, although it looks that the layout of the power supply wirings has become complicated at first sight in the present embodiment, the layout has been simplified in point of reduction of connecting portions and so forth, and improvement of reliability of the device and reduction in access time are aimed at.

### (Embodiment 2)

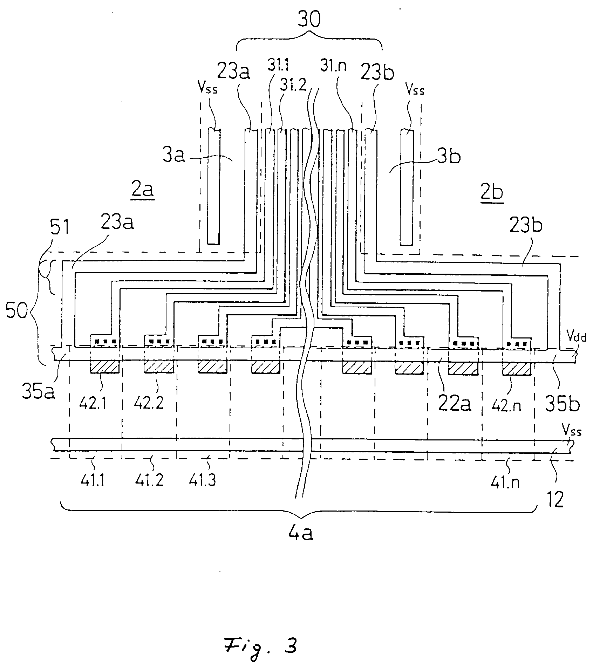

Fig. 3 shows details of the region II according to the embodiment 2 where the signal wirings 31.1 to 31.n are assembled in the common bus line 30. The layout of signal wirings 31.1 to 31.n, common bus line 30, row decoder circuits 3a and 3b, function cells 41.1 to 41.n, connecting portions 42.1 to 42.n and power supply wirings 23a and 23b is similar to that of above-described embodiment 1. Hence, the same numerals are assigned and description thereof will be omitted.

In the present embodiment, the point to be noticed is that the mother wiring 22a from which power supply wirings 23a and 23b are branched is used also as a power supply wiring to the peripheral circuit 4a. When the peripheral circuit 4a consists of a predecoder and the like and does not include a circuit having large power consumption such as a buffer circuit, potential deflection in the power supply wiring is small, and the mother wiring 22a may be used in common as a power supply of a decoder circuit. In such a device, it is possible to use the power supply wiring 22 and the mother wiring 22a of the decoder circuit as one power supply wiring by inverting the layout of the power supply wiring 12 of Vss and the power supply wiring 22 of Vdd of the peripheral circuit in the embodiment 1.

In the layout of the present embodiment, it is only required that the connecting portions 42.1 to 42.n formed under the power supply wiring 22a have the length which makes it possible to exchange interference with one line's portion of the wiring, thereby enabling it to reduce the resistance of the signal wirings 31.1 to 31.n. Further, since it is also possible to reduce the quantity of power supply wirings, it is possible to aim at simplification of the layout.

As described above, in a semiconductor integrated circuit such as a memory chip according to the present invention, the problems related with interference among the common bus line and power supply wirings which have caused problems in points of reliability and obtaining high access speed of the common bus line arranged with a plurality of wirings which increase as the memory capacity and the like increase are solved by arranging the mother power supply wiring branched to the bus line in the vicinity of the processing circuit of the signal wirings arranged in the common bus line. Accordingly, the layout adopted to solve above-described problems may be called not a complicated layout, but rather a simplified layout in such a point that reduction of connecting portions is aimed at as compared with a layout of a conventional semiconductor integrated circuit. It is a matter of course that the manufacturing process will never become more complicated than a conventional semiconductor integrated circuit.

Besides, polycrystalline silicon is used as signal wirings in the second layer in above-described embodiments, but it is needless to say that aluminum wirings may be used.

### Industrial Availability

The layout of power supply wirings is applicable to a memory chip such as a ROM and a RAM. Further, it is a matter of course, the layout may be adopted not only in a memory chip, but also in a semiconductor integrated circuit mounted with memory cells. Moreover, the present invention is applicable to a semiconductor integrated circuit in which a layout obtained by combining wirings of a common bus line system with signal processing circuits is used.

## Claims

1. A semiconductor integrated circuit device comprising:
memory cell regions including a plurality of memory cell blocks (2a, 2b, 2c, 2d),
decoder circuits (3a, 3b, 3c, 3d) arranged among the memory cell blocks,
signal processing circuits (4a, 4b) forming peripheral circuits arranged in the periphery of the memory cell regions,
a common bus line (30) extending in a first direction and including respective first portions of a plurality of signal wirings (31.1-31.n) assembled in parallel between a pair of first and second power supply wirings (23a, 23b), said signal wirings (31.1-31.n) being for connection of said decoder circuits (3a, 3b, 3c, 3d) to said peripheral circuits (4a, 4b), and said first and second power supply wirings being branched from a mother power supply wiring (22a) extending in a second direction substantially perpendicular to said first direction,
discretely arranged connecting regions (42.1-42.n) connecting said plurality of signal wirings (31.1-31.n) to said peripheral circuits, the arrangement of connecting regions extending in said second direction and having a width wider than the width of the common bus line, and
an assembling region (50) between said decoder circuits (3a, 3b, 3c, 3d) and said peripheral circuits (4a, 4b) where respective second portions of said signal wirings (31.1-31.n) connect to said connecting regions,
wherein said mother power supply wiring (22a) and the signal wirings (31.1-31.n) are formed in a first wiring layer and the connection regions (42.1-42.n) are formed in a second wiring layer below or above the first wiring layer with an insulating layer in between the first and second wiring layers, and wherein
said mother power supply wiring (22a) is arranged so as to intersect said connecting regions (42.1-42.n), and the branch points (35a, 35b) of said first and second power supply wirings (23a, 23b) frcm said mother power supply wiring (22a) are positioned on either side outside of the arrangement of said connection regions (42.1-42.n) such that the signal wirings do not intersect the power supply wiring.

2. The device of claim 1, wherein the mother power supply wiring (22a) is arranged in parallel to power supply wirings (12, 22) of the signal processing circuits (4a, 4b).

3. The device of claim 1, wherein the mother power supply wiring (22a) is a power supply wiring of the signal processing circuits (4a, 4b).

4. The device of any one of claims 1 to 3, wherein said mother power supply wiring (22a) is arranged at a right angle to said common bus line (30).

5. The device of any one of claims 1 to 4, wherein the first wiring layer is an aluminum layer and the second wiring layer is an aluminum or polycrystalline layer.

## Patentansprüche

1. Integrierte Halbleiterschaltungs-Vorrichtung, umfassend:
Speicherzellenbereiche mit einer Mehrzahl von Speicherzellenblöcken (2a, 2b, 2c, 2d),
Decoderschaltungen (3a, 3b, 3c, 3d), die zwischen den Speicherzellenblöcken angeordnet sind,
Signalverarbeitungsschaltungen (4a, 4b), die in der Peripherie der Speicherzellenbereiche angeordnete Peripherieschaltungen bilden,
eine gemeinsame Busleitung (30), die sich in einer ersten Richtung erstreckt und jeweils erste Abschnitte einer Mehrzahl von Signalverdrahtungen (31.1 - 31.n) aufweist, die parallel zwischen einem Paar aus einer ersten und einer zweiten Stromversorgungsverdrahtung (23a, 23b) gebündelt sind, wobei die Signalverdrahtungen (31.1 - 31.n) für den Anschluß der Decoderschaltungen (3a, 3b, 3c, 3d) an die Peripherieschaltungen (4a, 4b) bestimmt sind und die erste sowie die zweite Stromversorgungsverdrahtung von einer Hauptstromversorgungsverdrahtung (22a) abzweigen, welche sich in einer zweiten Richtung im wesentlichen senkrecht zur ersten Richtung erstreckt,
einzeln angeordnete Anschlußbereiche (42.1 - 42.n), die die Mehrzahl von Signalverdrahtungen (31.1 - 31.n) mit den Peripherieschaltungen verbindet, wobei sich die Anordnung der Anschlußbereiche in der zweiten Richtung erstreckt und eine Breite aufweist, die größer als die Breite der gemeinsamen Busleitung ist, und
einen Bündelungsbereich (50) zwischen den Decoderschaltungen (3a, 3b, 3c, 3d) und den Peripherieschaltungen (4a, 4b), in dem jeweilige zweite Abschnitte der Signalverdrahtungen (31.1 - 31.n) die Verbindungen zu den Anschlußbereichen herstellen,
wobei die Hauptstromversorgungsverdrahtung (22a) und die Signalverdrahtungen (31.1 - 31.n) in einer ersten Verdrahtungsschicht gebildet und die Anschlußbereiche (42.1 - 42.n) in einer zweiten Verdrahtungsschicht unterhalb oder oberhalb der ersten Verdrahtungsschicht mit einer Isolierschicht zwischen der ersten und der zweiten Verdrahtungsschicht gebildet sind, und wobei
die Hauptstromversorgungsverdrahtung (22a) so angeordnet ist, daß sie die Anschlußbereiche (42.1 - 42.n) kreuzt, und die Verzweigungspunkte (35a, 35b) der ersten und der zweiten Stromversorgungsverdrahtung (23a, 23b) von der Hauptstromversorgungsverdrahtung (22a) beidseitig außerhalb der Anordnung der Anschlußbereiche (42.1 - 42.n) derart positioniert sind, daß die Signalverdrahtungen die Stromversorgungsverdrahtung nicht kreuzen.

2. Vorrichtung nach Anspruch 1, bei der die Hauptstromversorgungsverdrahtung (22a) parallel zu Stromversorgungsverdrahtungen (12, 22) der Signalverarbeitungsschaltungen (4a, 4b) angeordnet ist.

3. Vorrichtung nach Anspruch 1, bei der die Hauptstromversorgungsverdrahtung (22a) eine Stromversorgungsverdrahtung der Signalverarbeitungsschaltungen (4a, 4b) ist.

4. Vorrichtung nach einem der Ansprüche 1 bis 3, bei der die Hauptstromversorgungsverdrahtung (22a) im rechten Winkel zur gemeinsamen Busleitung (30) angeordnet ist.

5. Vorrichtung nach einem der Ansprüche 1 bis 4, bei der die erste Verdrahtungsschicht eine Aluminiumschicht und die zweite Verdrahtungsschicht eine Aluminium- oder polykristalline Schicht ist.

## Revendications

1. Dispositif à circuit intégré à semi-conducteur comportant :
des régions de cellules de mémoire incluant une pluralité de blocs (2a, 2b, 2c, 2d) de cellules de mémoire,
des circuits (3a, 3b, 3c, 3d) décodeurs agencés parmi les blocs de cellules de mémoire,
des circuits (4a, 4b) de traitement de signal formant des circuits périphériques agencés dans la périphérie des régions de cellules de mémoire,
une ligne (30) de bus commun s'étendant dans une première direction et comportant des premières parties respectives d'une pluralité de câbles (31.1 à 31.n) de signaux assemblés en parallèle entre une paire de premier et second câbles (23a, 23b) d'alimentation en puissance, les câbles (31.1 à 31.n) de signaux étant pour la connexion des circuits (3a, 3b, 3c, 3d) décodeurs aux circuits (4a, 4b) périphériques, et les premier et second câbles d'alimentation en puissance étant branchés à partir d'un câble (22a) d'alimentation en puissance mère s'étendant dans une seconde direction sensiblement perpendiculaire à la première direction,
des régions (42.1 à 42.n) de connexion agencées de manière discrète reliant la pluralité de câbles (31.1 à 31.n) de signaux aux circuits périphériques, l'agencement des régions de connexion s'étendant dans la seconde direction et ayant une largeur plus grande que la largeur de la ligne de bus commun, et
une région (50) d'assemblage entre les circuits (3a, 3b, 3c, 3d) décodeurs et les circuits (4a, 4b) périphériques où des secondes parties respectives des câbles (31.1 à 31.n) de signaux connectent aux régions de connexion,
dans lequel le câble (22a) d'alimentation en puissance mère et les câbles (31.1 à 31.n) de signaux sont formés dans une première couche de câblage et les régions (42.1 à 42.n) de connexion sont formées dans une seconde couche de câblage au dessous ou au-dessus de la première couche de câblage avec une couche isolante intercalée entre les première et seconde couches de câblage, et dans lequel
le câble (22a) d'alimentation en puissance mère est agencé de manière à croiser les régions (42.1 à 42.n) de connexion, et les points (35a, 35b) de branchement des premier et second câbles (23a, 23b) d'alimentation en puissance du câble (22a) d'alimentation en puissance mère sont positionnés d'un côté ou de l'autre à l'extérieur de l'agencement des régions (42.1 à 42.n) de connexion de sorte que les câbles de signaux ne croisent pas le câble d'alimentation en puissance.

2. Dispositif suivant la revendication 1, dans lequel le câble (22a) d'alimentation en puissance mère est agencé parallèlement aux câbles (12, 22) d'alimentation en puissance des circuits (4a, 4b) de traitement de signal.

3. Dispositif suivant la revendication 1, dans lequel le câble (22a) d'alimentation en puissance mère est un câble d'alimentation en puissance des circuits (4a, 4b) de traitement de signal.

4. Dispositif suivant l'une quelconque des revendications 1 à 3, dans lequel le câble (22a) d'alimentation en puissance mère est agencé à angle droit par rapport à la ligne (30) de bus commun.

5. Dispositif suivant l'une quelconque des revendications 1 à 4, dans lequel la première couche de câblage est une couche en aluminium et la seconde couche de câblage est une couche en aluminium ou polycristalline.
